# EUROPÄISCHE PATENTSCHRIFT

(11) **EP 0 603 540 B1**
(45) Veröffentlichungstag und Bekanntmachung des Hinweises auf die Patenterteilung: **05.03.1997**
(21) Anmeldenummer: 93118537.5
(22) Anmeldetag: 18.11.1993
(51) Int. Cl.: H02H 9/00, H02H 7/085

(54) **Schaltungsanordnung zum Messen eines pulsierenden Gleichstroms**
Circuit device for measuring a pulsating DC-current
Circuit pour la mesure d'un courant continu pulsé

(30) Priorität: 19.12.1992 DE 4243138; 18.09.1993 DE 4331797
(43) Veröffentlichungstag der Anmeldung: 29.06.1994
(73) Patentinhaber: ROBERT BOSCH GMBH, 70442 Stuttgart (DE)
(72) Erfinder: Siegwart, Bernhard, Dipl.Ing. (FH), D-71679 Asperg (DE); Spaeth, Matthias, Dipl.-Ing., D-71696 Möglingen (DE)

(56) Entgegenhaltungen:
- EP-A- 0 478 808
- FR-A- 2 309 064
- US-A- 3 748 534
- PATENT ABSTRACTS OF JAPAN vol. 12, no. 313 (P-749) 25. August 1988 & JP-A-63 081 276 (KOSUKE HARADA) 12. April 1988
- PATENT ABSTRACTS OF JAPAN vol. 16, no. 209 (P-1354) 18. Mai 1992 & JP-A-04 036 666 (SHIMADZU) 6. Februar 1992

## Beschreibung

### Stand der Technik

Die Erfindung geht aus von einer Schaltungsanordnung zum Messen eines pulsierenden Gleichstroms nach der Gattung des Patentanspruchs. Derartige Schaltungsanordnungen sind grundsätzlich in vielen technischen Bereichen bekannt und besonders sicherheitsrelevant. So ist zum Beispiel der Strom eines Gleichstrommotors ein Maß für das von ihm abgegebene Moment, was zum Beispiel zur indirekten Erfassung und Begrenzung der ausgeübten Kraft genutzt wird. Als Beispiel seien Torantriebe genannt, bei denen über die Begrenzung des Motorstroms Schäden oder Verletzungen verhindert werden. Ist hierbei der Motorstrom ein pulsierender Gleichstrom, zum Beispiel aus einer Gleichrichterbrücke, so ist für eine exakte Messung eine Glättung des Meßwertes notwendig. Hierzu sind Glättungsschaltungen mit einem RC-Glied üblich, um den an einem Shunt gemessenen Strom zu glätten, wobei die Messung der Shuntspannung gegen Masse erfolgt.

### Vorteile der Erfindung

Die erfindungsgemäße Schaltungsanordnung mit den kennzeichnenden Merkmalen des Patentanspruchs hat gegenüber bekannten Schaltungen den Vorteil, daß die Glättungsschaltung eigensicher wirkt. Dies bedeutet, daß auch noch bei einem Kondensatorkurzschluß, der als besonders kritischer Fehler auftreten kann, die Überwachungsschaltung nicht unwirksam wird. Bei einer herkömmlichen Schaltung, bei der der Glättungskondensator mit einer Elektrode an Masse liegt, kann bei Kondensatorkurzschluß keine Meßspannung mehr erfaßt und somit ein Fehler nicht erkannt werden, weil die Ausgangsspannung des Glättungsglieds in diesem Fall zu Null wird. Ein Überstrom kann daher keine Fehlerauslösung mehr bewirken. Dies ist deshalb besonders gefährlich, weil der Kondensatordeffekt nicht augenfällig ist. Im Gegensatz hierzu wird bei der erfindungsgemäßen Schaltungsanordnung im Fall eines Kondensatorkurzschlusses die Ausgangsspannung der Schaltungsanordnung gleich der Versorgungsspannung, wodurch ein hoher Motorstrom simuliert und die Fehlerabschaltung bewirkt wird. Der Defekt im Glättungskondensator wird außerdem sofort augenfällig und kann behoben werden.

Für den Fehlerfall einer Unterbrechung des Kondensators entstehen keine Nachteile, vielmehr wirkt hier die erfindungsgemäße Schaltung in gleicher Weise wie die herkömmliche Schaltung eigensicher. Die Ausgangsspannung folgt dann der Spannung am Shunt, wobei aufgrund von Überströmen entsprechende Spannungsabfälle am Shunt entstehen und die ungeglätteten Spitzenwerte, die über dem tatsächlichen Mittelwert liegen, die Fehleranzeige oder die Auslösung einer Überwachungsschaltung bewirken. Es wird also in diesem Fall ein größerer Strom angezeigt, als er tatsächlich fließt, so daß auch hierbei ein Fehler rechtzeitig erkannt werden kann.

### Zeichnung

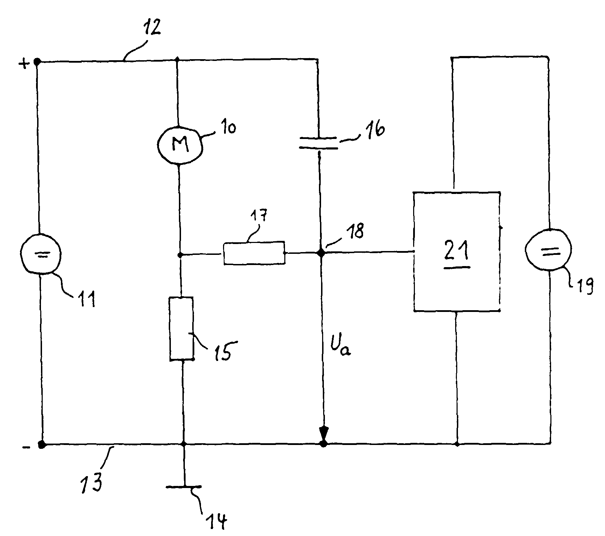

Ein Ausführungsbeispiel der Erfindung ist in der Zeichnung dargestellt und in der nachfolgenden Beschreibung erläutert. Die Figur zeigt ein Prinzipschaltbild der erfindungsgemäßen Glättungsschaltung.

### Beschreibung des Ausführungsbeispiels

In der Figur ist mit 10 ein Gleichstrommotor bezeichnet, welcher aus einer Gleichstromquelle 11 gespeist wird. Bei der Gleichstromquelle handelt es sich beispielsweise um eine mit Wechselstrom gespeiste Gleichrichterbrücke, welche einen welligen Gleichstrom an die positiven und negativen Versorgungsleitungen 12 und 13 abgibt. Die negative Versorgungsleitung 13 ist mit Masse 14 verbunden.

Zwischen den Versorgungsleitungen 12, 13 ist die Reihenschaltung des Gleichstrommotors 10 und eines Shunts 15 angeschlossen. Parallel zum Gleichstrommotor 10 liegt die Reihenschaltung eines Glättungskondensators 16 und eines Glättungswiderstandes 17. Die Meßspannung wird als Ausgangsspannung Uₐ zwischen einem Verbindungspunkt 18 zwischen Glättungskondensator 16 und Glättungswiderstand 17 sowie dem Masseanschluß 14 abgenommen und von einer Auswerteschaltung 21 ausgewertet, die ihrerseits wiederum von einer Gleichstromquelle 19 gespeist wird. Die Gleichstromquelle 19 kann mit der Gleichstromquelle 11 identisch sein, muß es aber nicht.

Beim Ansteigen des Speisestroms des Gleichstrommotors 10 steigt auch die Meßspannung am Shunt 15. Die Welligkeit des Speisestroms wird über das RC-Glied 16, 17 weitestgehend geglättet, wobei der vom Glättungswiderstand 17 abgewandte Belag des Glättungskondensators 16 nicht unmittelbar, sondern über den geringen Innenwiderstand Ri der Gleichstromquelle 11 mit Masse verbunden ist. Dieser Innenwiderstand ist so niedrig, daß ein sehr guter Glättungseffekt erreicht wird und kein Nachteil gegenüber einer direkten Masseverbindung des Glättungskondensators 16 entsteht. Andererseits erreicht man durch die vorgeschlagene Schaltung, daß bei einem Kurzschluß im Glättungskondensator 16 die Ausgangs-Meßspannung Uₐ auf den Wert der Versorgungsspannung durch die Gleichstromquelle 11 ansteigt und einen Fehler anzeigt, der unverzüglich zur Erkennung des Kondensatorkurzschlusses führt.

## Patentansprüche

1. Schaltungsanordnung zum Messen eines pulsierenden Gleichstroms eines einen Gleichstrom ziehenden Verbrauchers, insbesondere eines Gleichstrommotors, mit einem in den Stromkreis geschalteten Shunt (15) und mit einer Glättungsschaltung (16, 17) mit einem RC-Glied, dadurch gekennzeichnet, daß ein Glättungskondensator (16) des RC-Gliedes (16, 17) einerseits über einen Glättungswiderstand (17) an den mit dem Verbraucher verbundenen Anschluß des Shunts (15) in dem zu überwachenden Strompfad (12, 13) und andererseits an den positiven Pol (+) einer Gleichstromquelle (11) angeschlossen ist, derart, daß die Spannung (Uₐ) zwischen dem von der Gleichstromquelle (11) abgewandten Belag des Glättungskondensators (16) und der Masse (14) zur Messung des Gleichstroms dient.

## Claims

1. Circuit arrangement for measuring a pulsating direct current of a load which draws direct current, in particular of a DC motor, having a shunt (15) which is connected in the circuit and having a smoothing circuit (16, 17) with an RC element, characterized in that a smoothing capacitor (16) of the RC element (16, 17) is connected on the one hand via a smoothing resistor (17) to that connection of the shunt (15) which is connected to the load, in the current path (12, 13) to be monitored, and is connected on the other hand to the positive pole (+) of a DC source (11), in such a manner that the voltage (Uₐ) between that plate of the smoothing capacitor (16) which faces away from the DC source (11) and earth (14) is used for measuring the direct current.

## Revendications

1. Circuit de mesure d'un courant continu pulsé d'un utilisateur utilisant un courant continu, notamment d'un moteur à courant continu comprenant un shunt (15) branché dans le circuit de courant et un circuit de lissage (16, 17) comprenant un élément RC,
caractérisé en ce qu'
un condensateur de lissage (16) de l'élément RC (16, 17) est, d'une part, relié par une résistance de lissage (17) à la borne du shunt (15) reliée à l'utilisateur avec le chemin de courant (12, 13) à surveiller et, d'autre part, au pôle positif (+) d'une source de courant continu (11) de façon que la tension (Uₐ), entre le revêtement du condensateur de lissage (16), opposée à la source de courant continu (11) et la masse (14) serve à la mesure du courant continu.
